(19) Europäisches Patentamt / European Patent Office / Office européen des brevets

(11) **EP 4 741 854 A1**

(12) **EUROPEAN PATENT APPLICATION**
published in accordance with Art. 153(4) EPC

(43) Date of publication:
**13.05.2026 Bulletin 2026/20**

(21) Application number: **24856727.3**

(22) Date of filing: **12.08.2024**

(51) International Patent Classification (IPC):
*G01R 31/392* (2019.01)    *G01R 31/385* (2019.01)
*G01R 31/3828* (2019.01)    *G01R 19/165* (2006.01)
*G01R 31/371* (2019.01)    *G01R 31/36* (2020.01)

(52) Cooperative Patent Classification (CPC):
**G01R 19/165; G01R 31/36; G01R 31/371;
G01R 31/3828; G01R 31/385; G01R 31/392;
Y02E 60/10**

(86) International application number:
**PCT/KR2024/011992**

(87) International publication number:
**WO 2025/042115 (27.02.2025 Gazette 2025/09)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **18.08.2023 KR 20230108629**

(71) Applicant: **LG Energy Solution, Ltd.
Seoul 07335 (KR)**

(72) Inventor: **BYUN, Ha Eun
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY DIAGNOSIS DEVICE AND BATTERY DIAGNOSIS METHOD**

(57)    A battery diagnosis apparatus disclosed herein includes a sensor unit configured to obtain battery cell information for each of at least one battery cells and a control unit configured to determine a state of health (SOH) of each of the at least one battery cells based on the battery cell information and determine whether a defect occurs in the at least one battery cells based on an average and a standard deviation of the SOHs.

FIG.2

**Description**

## TECHNICAL FIELD

CROSS-REFERENCE TO RELATED APPLICATION

This application claims priority to and the benefit of Korean Patent Application No. 10-2023-0108629 filed in the Korean Intellectual Property Office on August 18, 2023, the entire content of which is incorporated herein by reference.

TECHNICAL FIELD

Embodiments disclosed herein relate to a battery diagnosis apparatus and a battery diagnosis method for diagnosing a state of a battery.

## BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles.

As the occurrence of defective battery cells, such as tab disconnection or lithium precipitation, in the battery may cause safety issues during battery use, research is being conducted on a defective battery cell detection algorithm. Conventionally, as a defective battery cell has a smaller capacity than a normal battery cells, a diagnosis target battery cell is diagnosed as a defective battery cell when having a state of health (SOH) less than an SOH median value in a battery module by a predetermined level. However, this method is applicable to a case when a battery system has a function of estimating an SOH, and thus is difficult to apply to a battery system having no SOH estimation algorithm, and the algorithm depends on the accuracy of SOH estimation.

## DISCLOSURE

## TECHNICAL PROBLEM

According to an embodiment disclosed herein, there are provided a battery diagnosis apparatus and a battery diagnosis method based on a battery capacity deviation without relying on whether a battery has a state of health (SOH) estimation algorithm or not.

Technical problems of the embodiments disclosed herein are not limited to the above-described technical problems, and other unmentioned technical problems would be clearly understood by one of ordinary skill in the art from the following description.

## TECHNICAL SOLUTION

A battery diagnosis apparatus according to an embodiment includes a sensor unit configured to obtain battery cell information for each of at least one battery cells and a control unit configured to determine a state of health (SOH) of each of the at least one battery cells based on the battery cell information and determine whether a defect occurs in the at least one battery cells based on an average and a standard deviation of the SOHs.

The control unit may be configured to determine that an abnormality has occurred in the cooling control based on a first condition in which the deviation is greater than or equal to a first reference value for a first reference time.

The control unit may be further configured to determine, as a reference SOH, a value obtained by excluding the standard deviation from the average of the SOHs and determine that a defect occurs in the battery cell based on that the SOHs of the at least one battery cells are less than the reference SOH.

The standard deviation may be determined as a value greater between the standard deviation calculated based on the SOH of each of the at least one battery cells and a preset reference standard deviation.

The control unit may be further configured to determine an open circuit voltage (OCV) of the at least one battery cells and determine that a defect occurs in the battery cell based on that the OCV is greater than a reference OCV obtained by excluding an OCV deviation from an average OCV.

The control unit may be further configured to determine the SOH of each of the at least one battery cell by applying a current detected by the sensor unit to a current integration method.

The control unit may be further configured to transmit the battery cell information including the defect occurring to an external device, based on the determining of that the defect occurs in the at least one battery cells.

A battery diagnosis method according to an embodiment includes obtaining battery cell information for each of at least one battery cells, determining a state of health (SOH) of each of the at least one battery cells based on the battery cell information, and determining whether a defect occurs in the at least one battery cells based on an average and a standard deviation of the SOHs.

The determining of whether the defect occurs in the at least one battery cells may include determining, as a reference SOH, a value obtained by excluding the standard deviation from the average of the SOHs and determining that a defect occurs in the battery cell based on that the SOHs of the at least one battery cells are less than the reference SOH.

The average of the SOHs may include an average of preset top SOHs among the SOHs of the at least one battery cells.

The standard deviation may be determined as a value greater between the standard deviation calculated based on the SOH of each of the at least one battery cells and a preset reference standard deviation.

The determining of whether the defect occurs in the at least one battery cells may include determining an open circuit voltage (OCV) of the at least one battery cells and determining that a defect occurs in the battery cell based on that the OCV is greater than a reference OCV obtained by excluding an OCV deviation from an average OCV.

The determining of the SOH of each of the at least one battery cells may include determine the SOH of each of the at least one battery cell by applying a current detected by a sensor unit to a current integration method.

The battery diagnosis method according to an embodiment may further include transmitting the battery cell information including the defect occurring to an external device, based on the determining of that the defect occurs in the at least one battery cells.

## ADVANTAGEOUS EFFECTS

With a battery diagnosis apparatus according to an embodiment, it may be determined whether a defect occurs in a battery cell by estimating a state of health (SOH) of a battery, thereby preventing capacity degradation, gradual swelling, ignition, etc., from occurring due to occurrence of the defect in the battery cell.

With the battery diagnosis apparatus according to an embodiment, even when there is no SOH estimation logic in a battery system or estimation accuracy is low, a defect of a battery cell may be detected, thereby reducing a cost for including a separate SOH estimation logic.

With the battery diagnosis apparatus according to an embodiment, a standard deviation may be used in an SOH comparison process, thereby preventing over-diagnosis.

## DESCRIPTION OF DRAWINGS

FIG. 1 is a block diagram showing a configuration of a general battery system including a battery diagnosis apparatus according to an embodiment.

FIG. 2 is a block diagram showing a configuration of a battery diagnosis apparatus according to an embodiment.

FIG. 3 schematically shows a flow for determining whether a defect occurs in a battery cell in a battery diagnosis apparatus according to an embodiment.

FIG. 4 shows a graph used by a battery diagnosis apparatus for SOH estimation, according to an embodiment.

FIG. 5 shows another graph used by a battery diagnosis apparatus for SOH estimation, according to an embodiment.

FIG. 6 is a flowchart of a battery diagnosis method according to an embodiment.

FIG. 7 is a flowchart continuously showing the battery diagnosis method of FIG. 6.

## MODE FOR INVENTION

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1st", "2nd", "first", "second", or the like may modify various components regardless of importance, and do not limit the components. For example, a first component may be named as a second component without departing from the right scope of an embodiment disclosed herein, and similarly, the second component may be named as the first component.

Terms used herein are used for only describing a specific exemplary embodiment and may not have an intention to limit the scope of other exemplary embodiments. It is to be understood that the singular forms include plural references unless the context clearly dictates otherwise.

All terms including technical or scientific terms used herein have the same meaning as commonly understood by those of ordinary skill in the art to which the embodiments disclosed herein belong. It will be further understood that terms, such as those defined in commonly used dictionaries, should be interpreted as having a meaning that is identical to or similar with their meaning in the context of the relevant art and will not be interpreted in an idealized or overly formal sense unless expressly so defined herein. In some cases, the terms defined herein may be interpreted to exclude embodiments disclosed herein.

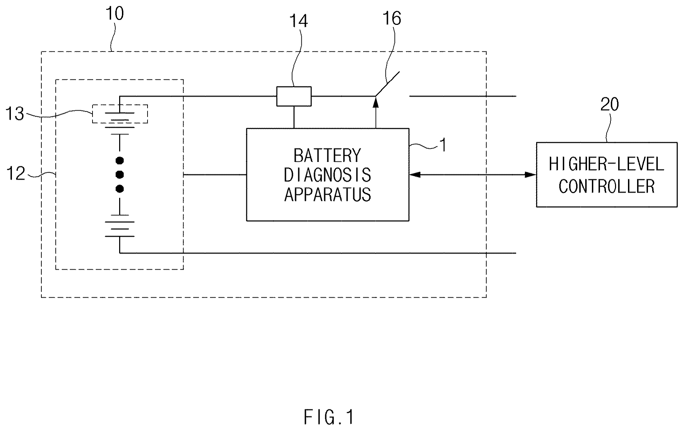

FIG. 1 is a block diagram showing a configuration of a general battery system including a battery management apparatus according to various embodiments.

Specifically, FIG. 1 schematically shows a battery system 10 and a higher-level control unit 20 included in a higher-level system according to an embodiment disclosed herein.

As shown in FIG. 1, the battery system 10 may include a plurality of battery modules 12, a sensor unit 14, a switching unit 16, and a battery diagnosis apparatus 1. The battery system 10 may include the battery module 12, the sensor unit 14, the switching unit 16, and the battery management apparatus 1 provided in plural.

The plurality of battery modules 12 may include at least one chargeable/dischargeable battery cells 13. The battery cell 13 may include a cathode, a cathode material, an anode, an anode material, a separator, polymer, and a case. In this case, the plurality of battery modules 12 may be connected in series or in parallel.

The sensor unit 14 may include a current sensor 2, a voltage sensor 3, and a temperature sensor (not shown).

The current sensor 2 may detect a current to be applied to a current integration method in a process of determining an SOH of the battery cell 13.

The current sensor 2 may include any component for generating a signal corresponding to a magnitude of a charging current, and may be installed on a charging/discharging path in which the charging/discharging current flows in a battery.

The current sensor 2 may measure a battery current flowing in the battery, i.e., a charging current and a discharging current, and transmit a measurement result to the battery diagnosis apparatus 1. According to an embodiment, the current sensor 2 may measure the battery current at predetermined intervals and transmit a measurement result to the battery diagnosis apparatus 1, in a charging cycle for charging the battery with power of an external device or a discharging cycle for discharging the battery.

The voltage sensor 3 may be connected in parallel with the battery and configured to detect a battery voltage across opposite ends of the battery and generate a voltage signal indicating the detected battery voltage.

The temperature sensor may be configured to measure a battery temperature and generate a temperature signal indicating the measured battery temperature. The temperature sensor may be disposed in a case to measure a temperature close to an actual temperature of the battery. For example, the temperature sensor may be attached to a surface of at least one battery cell included in a cell group and detect the surface temperature of the battery cell as the battery temperature.

The temperature sensor may be configured to measure an external temperature that is a temperature at a predetermined position spaced apart from the battery and generate the temperature signal indicating the measured external temperature. The temperature sensor may be arranged at a predetermined position outside the case in which heat exchange is made between the battery and the atmosphere. According to an embodiment, the temperature sensor may be implemented in combination of one or two or more of known temperature detection elements such as a thermocouple, a thermistor, a bimetal, etc. The sensor unit 14 may detect current flowing in the battery system 10. In this case, a detection signal may be transmitted to the battery diagnosis apparatus 1.

While the sensor unit 14 is connected between a positive electrode of the battery cell 13 and the switching unit 16 in FIG. 1, a connection relationship between components shown in FIG. 1 may be an example and is not limited thereto.

The switching unit 16 may be serially connected to a positive (+) terminal side or a negative (-) terminal side of the battery module 12 to control a charging/discharging current flow of the battery module 12. For example, for the switching unit 16, at least one relay, a magnetic contactor, etc., may be used, depending on the specification of the battery system 10.

The battery diagnosis apparatus 1 may perform control and management to prevent over-charging and over-discharging by monitoring voltage, current, temperature, etc., of the battery system 10, and may include, for example, a BMS.

The battery diagnosis apparatus 1, which is an interface for receiving measurement values of the above-described various parameter values, may include a plurality of terminals and a circuit, etc., connected thereto to process input values. Further, the battery diagnosis apparatus 1 may control the switching unit 16, for example, on/off of a relay, a contactor, etc., and may be connected to the battery module 12 to monitor a state of each battery module 12.

The battery diagnosis apparatus 1 may receive temperature data, voltage data, and current data from the sensor unit 14 to obtain battery state information and diagnose a state of the battery.

The higher-level control unit 20 may transmit a control signal for controlling the battery module 12 to the battery diagnosis apparatus 1. Thus, the battery diagnosis apparatus 1 may be controlled in terms of an operation thereof based on the control signal applied from the higher-level control unit 20. Also, the battery module 12 may be a component included in an energy storage system (ESS). In this case, the higher-level control unit 20 may be a control unit (BBMS) of a battery bank including the plurality of battery systems 10 or an ESS control unit for controlling the entire ESS including a plurality of banks. However, the battery system 10 is not limited to such a purpose.

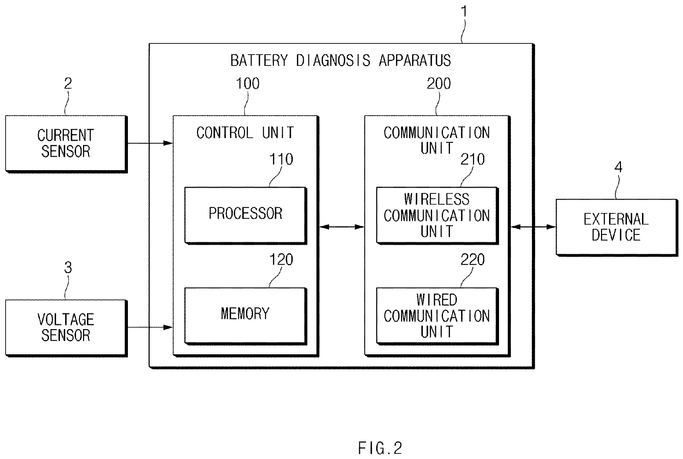

FIG. 2 is a block diagram showing a configuration of a battery diagnosis apparatus according to an embodiment.

Referring to FIG. 2, the battery diagnosis apparatus 1 according to an embodiment may include a control unit 100 including at least one processor 110 and a memory 120 and a communication unit 200, and may diagnose a battery by communicating with an external device 4 through the communication unit 200.

According to an embodiment, the external device 4 communicating with the battery diagnosis apparatus 1 may include a user terminal that transmits a diagnosis result of the battery diagnosis apparatus 1.

Specifically, when the external device 4 is a user terminal, the control unit 100 of the battery diagnosis apparatus 1 may transmit a diagnosis result of the battery to the user terminal to enable a user to check the diagnosis result. In this case, the user terminal may include, but not limited to, a personal computer (PC), a terminal, a portable telephone, a smart phone, a handheld device, a wearable device, etc.

The battery diagnosis apparatus 1 according to an embodiment may mean any electronic device including the processor 110 and the memory 120, and may be mounted on a vehicle to operate. Hereinbelow, each component of the battery diagnosis apparatus 1 may be described in detail.

The communication unit 200 may include a wireless communication unit 210 and a wired communication unit 220 to communicate with the external device 4. The communication unit 200 may transmit and receive a program for feature calculation, class classification, and lifespan estimation for a battery cell or various data, etc., to and from a separately provided external server.

The wireless communication unit 210 may include at least one of a short-range communication module or a long-range communication module.

The short-range communication module may communicate with the external device 5 adjacent to the battery diagnosis apparatus 1 by using a short-range communication method. Herein, the short-range communication module may use one communication method among Bluetooth, Bluetooth low energy (BLE), infrared data association (IrDA), Zigbee, WiFi, WiFi Direct, ultra wideband (UWB), or near field communication (NFC).

The long-range wireless communication module may include a communication module performing various types of long-range communication, and may include a mobile communication module. The mobile communication unit may transmit and receive a radio signal to and from at least one of a base station, an external terminal, or the external device 4 over a mobile communication network. The long-range communication module may communicate with the external device 4 or other electronic devices, etc., through a nearby access point (AP). The AP may connect a local area network (LAN) to which the battery diagnosis apparatus 1 is connected to a wide area network (WAN) to which the communication server is connected. Thus, the battery diagnosis apparatus 1 may be connected to the communication server through the external device 4 and the WAN to communicate with each other.

The wired communication unit 220 may access the wired communication network and communicate with the external device 4 through the wired communication network. For example, the wired communication unit 220 may access the wired communication network through Ethernet (IEEE 802.3, technical standards), access the wired communication network through CAN communication, and transmit and receive data to and from the external devices 4 through the wired communication network.

The battery diagnosis apparatus 1 according to an embodiment may include an input/output interface (not shown). An interface may be provided to allow data to be transmitted and received by connecting an input device (not shown) such as a keyboard, a mouse, a touch panel, etc., an output device such as a display (not shown), etc., and the processor 110.

The memory 120 may store various information required for driving of the battery diagnosis apparatus 1. Specifically, the memory 120 may store an operating system and a program required for driving of the battery diagnosis apparatus 1 or store data required for driving of the battery diagnosis apparatus 1.

Specifically, the memory 120 may store various programs regarding feature calculation, class classification, and lifespan estimation of the battery cell. Moreover, the memory 120 may store various data such as a voltage, a current, feature data, etc., of each battery cell.

The memory 120 may store an SOC and an SOH of the battery cell 13, estimated by the processor 110, and store an average and a standard deviation of the SOH calculated by the processor 110.

The memory 120 may include a volatile memory 120 such as a static random access memory (S-RAM) and a dynamic random access memory (D-RAM) to temporarily memorize data. The memory 120 may also include a non-volatile memory 120 such as a read only memory (ROM), an erasable programmable read only memory (EPROM), and an electrically erasable programmable read only memory (EEPROM), to store data for a long time.

The processor 110 may control in overall the battery diagnosis apparatus 1 by outputting a control signal. The processor 110 may include one CPU or graphics processing unit (GPU) or a plurality of CPUs or GPUs. In this case, the processor 110 may be implemented as an array of multiple logic gates, or may be implemented as a combination of the general-purpose microprocessor 110 and the memory 120 storing a program executable on the microprocessor 110.

The memory 120 and the processor 110 may be included in the control unit 100 that controls the above-described components to determine whether a failure occurs in a battery cell.

Specifically, the control unit 100 may determine an SOH of each of at least one battery cells 13 based on information of the battery cell 13 and determine whether a defect occurs in the at least one battery cell 13 based on an average and a standard deviation of SOHs.

The control unit 100 may determine a reference SOH by excluding the standard deviation from the average of the SOHs and determine that a defect occurs in the battery cell 13 based on that the SOH of the at least one battery cell 13 is less than the reference SOH.

The control unit 100 may determine an open circuit voltage (OCV) of the at least one battery cell 13 and determine that a defect occurs in the battery cell 13 based on that the OCV is greater than a reference OCV obtained by excluding an OCV standard deviation from an OCV average.

The control unit 100 may determine the SOH of each of the at least one battery cells 13 by applying the current detected by the sensor unit 14 to the current integration method, and transmit the information of the battery cell 13 having a defect occurring therein to the external device 4 based on that the defect occurs in the at least one battery cells 13.

Thus, the battery diagnosis apparatus 1 according to an embodiment may diagnose whether a defect occurs in the battery cell 3 based on the average and the standard deviation of the SOHs of the battery cells 13, thereby significantly improving the reliability of diagnosis.

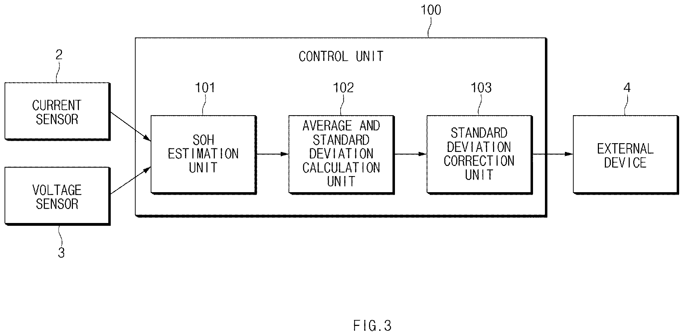

FIG. 3 schematically shows a flow for determining whether a defect occurs in a battery cell in a battery diagnosis apparatus according to an embodiment.

Referring to FIG. 3, the control unit 100 of the battery diagnosis apparatus 1 according to an embodiment may receive a battery current at a specific point in time from the current sensor 2 and receive a battery voltage at a specific point in time from the voltage sensor 3.

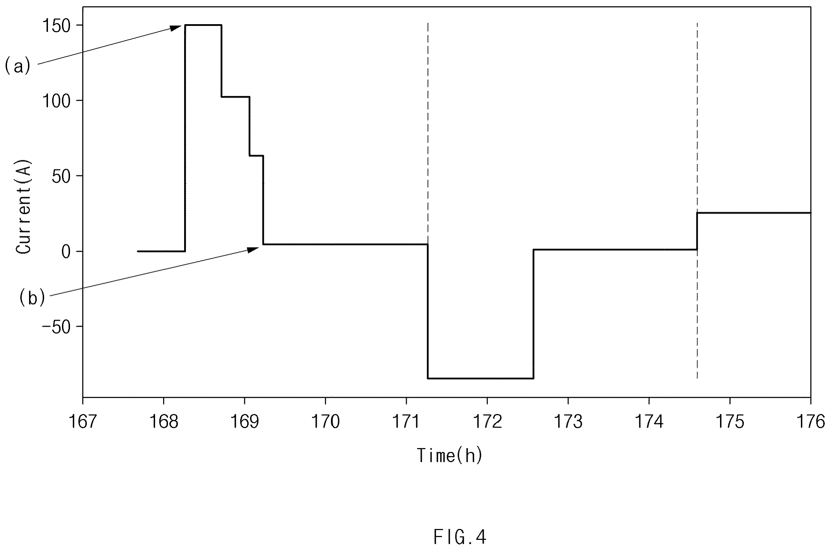

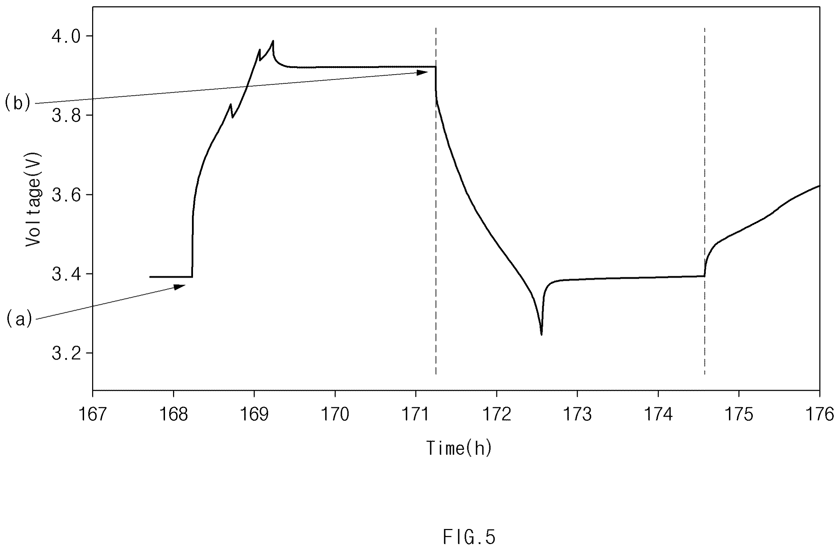

Thereafter, an SOH estimation unit of the control unit 100 may substitute a current and a voltage of the battery into a modified equation of an SOC equation to estimate the SOH. An SOH estimation method will be described with reference to FIGS. 4 and 5.

An average and standard deviation calculation unit of the control unit 100 may calculate an average of SOHs respectively estimated for the plurality of battery cells 13. That is, the control unit 100 may determine that a defect occurs in the diagnosis target battery cell 13 when the SOH of the diagnosis target battery cell 13 is less than the average of the SOHs respectively estimated for the plurality of battery cells 13. The SOH of the battery cell 13 may be affected by several charging conditions such as a depth of discharge (DOD), a start SOC, a current rate (C-rate), etc., such that the control unit 100 may perform diagnosis by comparing the SOH with a relative value in a battery module.

The average and standard deviation calculation unit of the control unit 100 may calculate the standard deviation of the SOHs respectively calculated for the plurality of battery cells 13 and use the standard deviation to detect whether the defect occurs in the diagnosis target battery cell 13.

Specifically, the control unit 100 may calculate an average and an standard deviation of to 50 % SOHs among the battery cells 13 in a battery module in which the top 50 % values may be changed by a manager. The control unit 100 may use an average and a standard deviation of top 50 % SOHs among the battery cells 13 in the battery module to prevent the average and the standard deviation of the SOHs from being distorted due to an influence of the battery cell 13 having the defect occurring therein.

The control unit 100 may determine, as the reference SOH, a value obtained by excluding n * standard deviation from the calculated average of the SOHs and determine that the defect occurs in the diagnosis target battery cell 13 when the SOH of the diagnosis target battery cell 13 is less than the reference SOH. Herein, n may mean a random constant value and may be changed by the manager.

The control unit 100 of the battery diagnosis apparatus according to an embodiment may use the following two methods to prevent over-diagnosis.

First, when a standard deviation of the battery cells 13 is small in a battery module including only normal battery cells 13, over-diagnosis may occur such that a standard deviation correction unit of the control unit 100 may compare a calculated standard deviation with a preset reference standard deviation and correct the standard deviation according to an equation of max(reference standard deviation, calculated standard deviation).

The control unit 100 may determine, as the reference SOH, a value obtained by excluding n * corrected standard deviation from the average of the SOHs and determine that the defect occurs in the diagnosis target battery cell 13 when the SOH of the diagnosis target battery cell 13 is less than the reference SOH.

Thus, in a battery module having a small standard deviation of the battery cells 13 therein, the battery cell 13 having some deviation is not defective, such that the control unit 100 may not perform diagnosis, thereby preventing over-diagnosis.

Second, when a battery is in a low-voltage state, a charging start OCV and a charging end OCV are relatively low and thus an SOH tends to be estimated less than an average, such that to prevent over-discharge correspondingly, the control unit 100 may determine that a defect occurs in the battery cell 13 when the charging end OCV of the diagnosis target battery cell 13 is greater than (charging end OCV average - n * charging end OCV standard deviation).

Thus, it is possible to prevent over-diagnosis in which diagnosis is excessively performed due to an estimated low SOH even when a defect occurs in the battery cell 13 in case of a low voltage of the battery.

Thereafter, the control unit 10 may transmit diagnosis results to the external device 4 when diagnosing that the defect occurs in the battery cell 13 and when diagnosing the battery cell 13 as normal. The diagnosis results may include a signal indicating the battery cell 13 as defective or normal and a diagnosis message indicating the battery cell 13 as defective or normal.

FIG. 4 shows a graph used by a battery diagnosis apparatus for SOH estimation, according to an embodiment, and FIG. 5 shows another graph used by a battery diagnosis apparatus for SOH estimation, according to an embodiment.

Referring to FIGS. 4 and 5 together, the control unit 100 may estimate an SOH of each battery cell 13 to diagnose whether the battery cell 13 is defective in the battery system 10 having no SOH estimation function.

The control unit 100 may determine a point (a) of FIG. 4 as a first current point current point1 and a point (b) as a second current point current point2, based on a charging/discharging cycle of the battery. The control unit 100 may determine a point (a) of FIG. 5 as a first voltage point voltage point1 and a point (b) as a second voltage point voltage point2.

The control unit 100 may modify an SOC equation (Equation 1) using the current integration method to determine an SOH. Specifically, Equation 1 may be modified into Equation 2 regarding a battery capacity, and values of a first current point, a second current point, a first voltage point, and a second voltage point may be substituted into Equation 2 to calculate the battery capacity. The control unit 100 may substitute the calculated battery capacity into Equation 3 regarding a battery capacity to estimate the SOH of the battery cell 13.

【Equation 1】

$$SOC(t)=SOC(t-1)+(I(t)/Q)\Delta t,(Q : battery\ cell\ capacity)$$

【Equation 2】

$$Q=(\int_{t_{current\ point1}}^{t_{current\ point2}} I(t)dt)/(SOC(OCV(voltagepoint2))-SOC(OCV(voltagepoint1)))$$

【Equation 3】

$$SOH=(Q/Q_r)\times100(\%),(Q_r:rated\ capacity)$$

Thus, even in the battery system 10 having no SOH estimation function, defect detection of the battery cell 13 may be possible without depending on an SOH estimation logic.

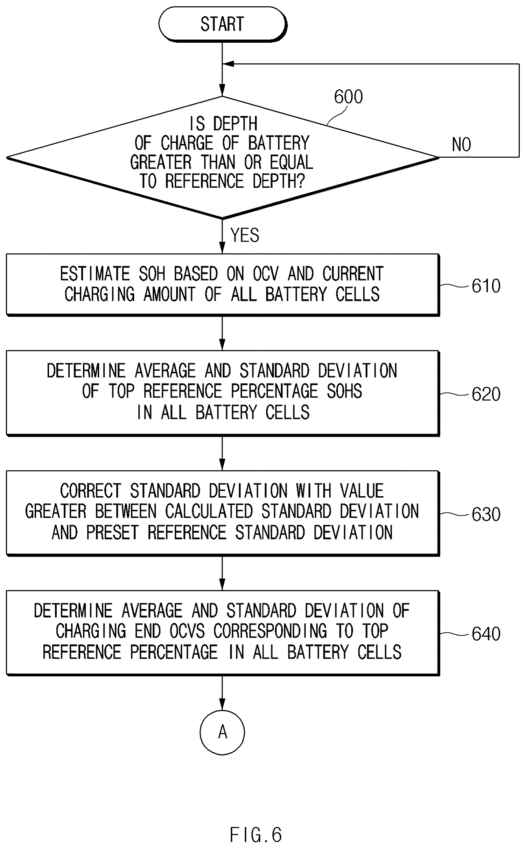

FIG. 6 is a flowchart of a battery diagnosis method according to an embodiment.

Referring to FIG. 6, the control unit 100 may determine whether a depth of charge of the battery is greater than or equal to a reference depth of charge with an event starting diagnosis of the battery, in operation 600. Herein, the depth of charge of the battery may mean a rate at which the battery is fully charged at a specific point in time based on a capacity fully charged from an initial state.

For example, the control unit 100 may start diagnosis for determining a defect of the battery cell 13 only when the depth of charge of the battery is greater than or equal to 50 %, and may return to an initial state without performing diagnosis when the depth of charge of the battery is less than a reference depth (No in operation 600).

That is, when the control unit 100 determines that the depth of charge of the battery is greater than or equal to the reference depth (Yes in operation 600), the control unit 100 may estimate the SOH of the battery cell 13 in the module based on an OCV and a current charging amount of all the battery cells 13 in operation 610. In this case, the control unit 100 may estimate the SOH of each battery cell 13 based on Equations 1 to 3 as described above.

The control unit 100 may determine an average and a standard deviation of SOHs corresponding to a top reference percentage of all the battery cells 13 in the module. That is, to prevent the defective battery cell 13 from affecting the average and the standard deviation, the control unit 100 may calculate an average and a standard deviation only for top n % SOHs in an order of higher SOHs.

The control unit 100 may correct a standard deviation with a greater value between the calculated standard deviation and a preset reference standard deviation, in operation 630. In this case, the reference standard deviation may be preset by the manager, and may mean a parameter for preventing over-diagnosis.

The control unit 100 may determine a charging end OCV corresponding to a top reference percentage among all the battery cells 13, for example, an average and a standard deviation of charging end OCVs of the battery cells 13 corresponding to top 50 %. That is, the control unit 100 may use an OCV to prevent over-diagnosis when the battery is in the low-voltage state as described above.

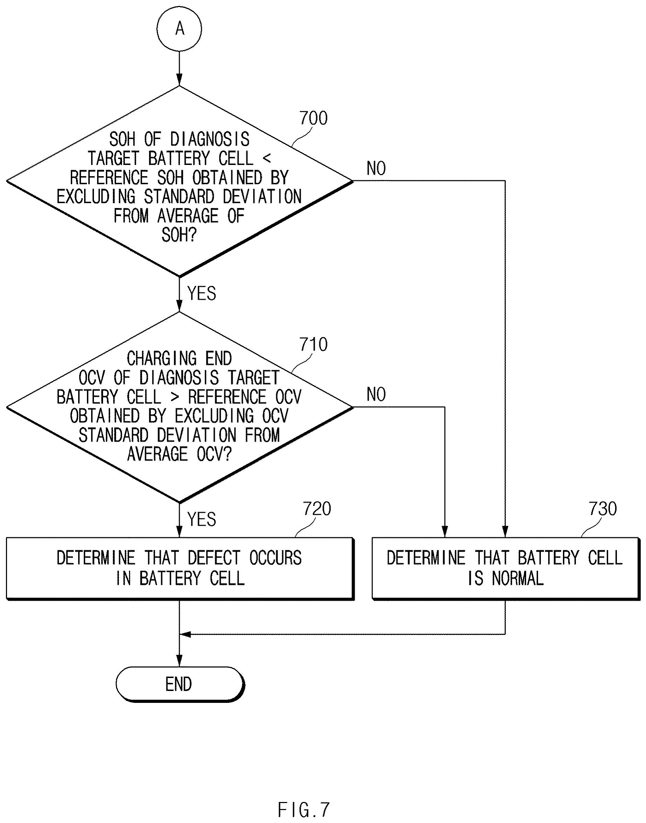

FIG. 7 is a flowchart continuously showing the battery diagnosis method of FIG. 6.

Referring to FIG. 7, the control unit 100 may determine that a defect occurs in the battery cell 13 when both an SOH condition and an OCV condition are satisfied.

Specifically, the control unit 100 may compare an SOH of the diagnosis target battery with a reference SOH obtained by excluding a standard deviation of the SOHs from an average of the SOHs, in operation 700.

In operation 730, the control unit 100 may determine that the diagnosis target battery cell 13 is normal when the SOH of the diagnosis target battery cell 13 is greater than or equal to the reference SOH (No in operation 700). That is, as the reference SOH is calculated based on an average of top n % SOHs among SOHs of the battery module, the control unit 110 may determine that the SOH of the diagnosis target battery cell 13 is at a normal level when the SOH of the diagnosis target battery cell 13 is greater than or equal to the reference SOH.

The control unit 100 may determine whether the diagnosis target battery cell 13 satisfies an OCV condition when the SOH of the diagnosis target battery cell 13 is less than the reference SOH (Yes in operation 700). Specifically, the control unit 100 may compare a charging end OCV of the diagnosis target battery cell 13 with a reference OCV obtained by excluding an OCV standard deviation from an average OCV, in operation 710.

In operation 730, the control unit 100 may determine that the diagnosis target battery cell 13 is normal when the charging end OCV of the diagnosis target battery cell 13 is less than or equal to the reference OCV (No of 710). That is, when the charging end OCV of the diagnosis target battery cell 13 is less than or equal to the reference OCV, it may mean that the battery is in the low-voltage state, such that the battery cell 13 may be determined as normal to prevent over-diagnosis.

When the charging end OCV of the diagnosis target battery cell 13 is greater than the reference OCV (Yes in operation 710), the control unit 100 may determine that the battery cell 13 is defective in operation 720 because the battery is not in the low-voltage state and there is no risk of over-diagnosis.

While it is shown in FIG. 7 that the OCV condition is determined after the SOH condition is determined, the order is not limited and the two conditions may be determined in parallel.

As such, the battery diagnosis apparatus 1 according to an embodiment may use the standard deviation for preventing over-diagnosis in addition to determining whether the battery cell 13 is defective simply based on the SOH, thereby enabling efficient diagnosis.

Meanwhile, disclosed embodiments may be implemented in the form of a recording medium that stores an instruction executable by a computer. The instruction may be stored in the form of a program code, and, when executed by a processor, may generate a program module and perform operations according to disclosed embodiments. The recording medium may be implemented as a computer-readable recording medium.

The computer-readable recording medium may include any type of recording media that store an instruction interpretable by a computer. For example, the computer-readable recording medium may include read-only memory (ROM), random-access memory (RAM), a magnetic tape, a magnetic disk, flash memory, an optical data storage device, etc.

In addition, the computer-readable recording medium may be provided in the form of a non-transitory storage medium. Herein, the term 'non-transitory storage medium' simply means that the storage medium is a tangible device, and does not include a signal (e.g., an electromagnetic wave), but this term does not differentiate between where data is semi-permanently stored in the storage medium and where the data is temporarily stored in the storage medium. For example, the 'non-transitory storage medium' may include a buffer storing data temporarily.

According to an embodiment of the disclosure, a method according to various embodiments of the disclosure may be included and provided in a computer program product. The computer program product may be traded as a product between a seller and a buyer. The computer program product may be distributed in the form of a machine-readable recording medium (e.g., compact disc read only memory (CD-ROM)), or be distributed (e.g., downloaded or uploaded) online via an application store (e.g., Play Store™), or between two user devices (e.g., smart phones) directly. When distributed online, at least a part of the computer program product (e.g., a downloadable app) may be temporarily generated or at least temporarily stored in the machine-readable recording medium, such as memory of the manufacturer's server, a server of the application store, or the memory 102 of a relay server.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

## Claims

1.  A battery diagnosis apparatus comprising:

    a sensor unit configured to obtain battery cell information for each of at least one battery cells; and
    a control unit configured to determine a state of health (SOH) of each of the at least one battery cells based on the battery cell information and determine whether a defect occurs in the at least one battery cells based on an average and a standard deviation of the SOHs.

2.  The battery diagnosis apparatus of claim 1, wherein the control unit is further configured to determine, as a reference SOH, a value obtained by excluding the standard deviation from the average of the SOHs and determine that a defect occurs in the battery cell based on that the SOHs of the at least one battery cells are less than the reference SOH.

3.  The battery diagnosis apparatus of claim 1, wherein the average of the SOHs comprises an average of preset top SOHs among the SOHs of the at least one battery cells.

4.  The battery diagnosis apparatus of claim 1, wherein the standard deviation is determined as a value greater between the standard deviation calculated based on the SOH of each of the at least one battery cells and a preset reference standard deviation.

5.  The battery diagnosis apparatus of claim 1, wherein the control unit is further configured to determine an open circuit voltage (OCV) of the at least one battery cells and determine that a defect occurs in the battery cell based on that the OCV is greater than a reference OCV obtained by excluding an OCV deviation from an average OCV.

6.  The battery diagnosis apparatus of claim 1, wherein the control unit is further configured to determine the SOH of each of the at least one battery cell by applying a current detected by the sensor unit to a current integration method.

7.  The battery diagnosis apparatus of claim 1, wherein the control unit is further configured to transmit the battery cell information comprising the defect occurring to an external device, based on the determining of that the defect occurs in the at least one battery cells.

8.  A battery diagnosis method comprising:

    obtaining battery cell information for each of at least one battery cells;
    determining a state of health (SOH) of each of the at least one battery cells based on the battery cell information; and
    determining whether a defect occurs in the at least one battery cells based on an average and a standard deviation of the SOHs.

9. The battery diagnosis method of claim 8, wherein the determining of whether the defect occurs in the at least one battery cells comprises determining, as a reference SOH, a value obtained by excluding the standard deviation from the average of the SOHs and determining that a defect occurs in the battery cell based on that the SOHs of the at least one battery cells are less than the reference SOH.

10. The battery diagnosis method of claim 8, wherein the average of the SOHs comprises an average of preset top SOHs among the SOHs of the at least one battery cells.

11. The battery diagnosis method of claim 8, wherein the standard deviation is determined as a value greater between the standard deviation calculated based on the SOH of each of the at least one battery cells and a preset reference standard deviation.

12. The battery diagnosis method of claim 8, wherein the determining of whether the defect occurs in the at least one battery cells comprises determining an open circuit voltage (OCV) of the at least one battery cells and determining that a defect occurs in the battery cell based on that the OCV is greater than a reference OCV obtained by excluding an OCV deviation from an average OCV.

13. The battery diagnosis method of claim 8, wherein the determining of the SOH of each of the at least one battery cells comprises determine the SOH of each of the at least one battery cell by applying a current detected by a sensor unit to a current integration method.

14. The battery diagnosis method of claim 8, further comprising transmitting the battery cell information comprising the defect occurring to an external device, based on the determining of that the defect occurs in the at least one battery cells.

FIG.1

FIG.2

100

CONTROL UNIT

2

CURRENT
SENSOR

VOLTAGE
SENSOR

3

101

SOH
ESTIMATION
UNIT

102

AVERAGE AND
STANDARD
DEVIATION
CALCULATION
UNIT

103

STANDARD
DEVIATION
CORRECTION
UNIT

4

EXTERNAL
DEVICE

FIG.3

FIG.4

EP 4 741 854 A1

FIG.5

START

↓

600

IS DEPTH
OF CHARGE OF BATTERY
GREATER THAN OR EQUAL
TO REFERENCE DEPTH?  —— NO

↓ YES

ESTIMATE SOH BASED ON OCV AND CURRENT
CHARGING AMOUNT OF ALL BATTERY CELLS  — 610

↓

DETERMINE AVERAGE AND STANDARD DEVIATION
OF TOP REFERENCE PERCENTAGE SOHS
IN ALL BATTERY CELLS  — 620

↓

CORRECT STANDARD DEVIATION WITH VALUE
GREATER BETWEEN CALCULATED STANDARD DEVIATION
AND PRESET REFERENCE STANDARD DEVIATION  — 630

↓

DETERMINE AVERAGE AND STANDARD DEVIATION OF
CHARGING END OCVS CORRESPONDING TO TOP
REFERENCE PERCENTAGE IN ALL BATTERY CELLS  — 640

↓

A

FIG.6

FIG.7

## INTERNATIONAL SEARCH REPORT

| International application No. |
|---|
| **PCT/KR2024/011992** |

| A. | CLASSIFICATION OF SUBJECT MATTER |
|---|---|

**G01R 31/392**(2019.01)i; **G01R 31/385**(2019.01)i; **G01R 31/3828**(2019.01)i; **G01R 19/165**(2006.01)i; **G01R 31/371**(2019.01)i; **G01R 31/36**(2006.01)i

According to International Patent Classification (IPC) or to both national classification and IPC

| B. | FIELDS SEARCHED |
|---|---|

Minimum documentation searched (classification system followed by classification symbols)

G01R 31/392(2019.01); G01R 31/36(2006.01); G01R 31/367(2019.01); G01R 31/382(2019.01); G01R 31/396(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), 노화도(State of Health, SOH), 표준 편차 (standard deviation), 평균(average), 개방 회로 전압(open circuit voltage, OCV)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | KR 10-2019-0012718 A (LG CHEM, LTD.) 11 February 2019 (2019-02-11)<br>See paragraphs [0049]-[0060] and claims 1 and 6. | 1,4,7-8,11,14 |
| Y | | 6,13 |
| A | | 2-3,5,9-10,12 |
| Y | KR 10-2021-0074004 A (LG ENERGY SOLUTION, LTD.) 21 June 2021 (2021-06-21)<br>See paragraphs [0064]-[0065] and claim 1. | 6,13 |
| A | KR 10-2021-0004646 A (LG CHEM, LTD.) 13 January 2021 (2021-01-13)<br>See claim 1 and figure 4. | 1-14 |
| A | KR 10-2014-0111920 A (SAMSUNG SDI CO., LTD.) 22 September 2014 (2014-09-22)<br>See paragraphs [0053]-[0056] and claims 1 and 5. | 1-14 |

[✓] Further documents are listed in the continuation of Box C.　　　[✓] See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **13 November 2024** | **13 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2024/011992** |

### C.    DOCUMENTS CONSIDERED TO BE RELEVANT

| Category* | Citation of document, with indication, where appropriate, of the relevant passages | Relevant to claim No. |
| --- | --- | --- |
| A | KR 10-2280709 B1 (THE INDUSTRY & ACADEMIC COOPERATION IN CHUNGNAM NATIONAL UNIVERSITY (IAC)) 21 July 2021 (2021-07-21)<br>See paragraphs [0038]-[0048] and claim 1. | 1-14 |

Form PCT/ISA/210 (second sheet) (July 2022)

**INTERNATIONAL SEARCH REPORT**
**Information on patent family members**

International application No.

**PCT/KR2024/011992**

| Patent document cited in search report | | | Publication date (day/month/year) | Patent family member(s) | | | Publication date (day/month/year) |
|---|---|---|---|---|---|---|---|
| KR | 10-2019-0012718 | A | 11 February 2019 | None | | | |
| KR | 10-2021-0074004 | A | 21 June 2021 | CN | 114402211 | A | 26 April 2022 |
| | | | | EP | 4024071 | A1 | 06 July 2022 |
| | | | | EP | 4024071 | B1 | 31 July 2024 |
| | | | | JP | 2022-548516 | A | 21 November 2022 |
| | | | | JP | 7332098 | B2 | 23 August 2023 |
| | | | | US | 2024-0085486 | A1 | 14 March 2024 |
| | | | | WO | 2021-118311 | A1 | 17 June 2021 |
| KR | 10-2021-0004646 | A | 13 January 2021 | CN | 113826021 | A | 21 December 2021 |
| | | | | EP | 3961233 | A1 | 02 March 2022 |
| | | | | EP | 3961233 | B1 | 11 September 2024 |
| | | | | JP | 2022-532545 | A | 15 July 2022 |
| | | | | JP | 7463008 | B2 | 08 April 2024 |
| | | | | US | 11815559 | B2 | 14 November 2023 |
| | | | | US | 2022-0221527 | A1 | 14 July 2022 |
| | | | | WO | 2021-006566 | A1 | 14 January 2021 |
| KR | 10-2014-0111920 | A | 22 September 2014 | CN | 104049213 | A | 17 September 2014 |
| | | | | EP | 2778700 | A2 | 17 September 2014 |
| | | | | US | 2014-0278169 | A1 | 18 September 2014 |
| KR | 10-2280709 | B1 | 21 July 2021 | KR | 10-2021-0088915 | A | 15 July 2021 |

Form PCT/ISA/210 (patent family annex) (July 2022)

**EP 4 741 854 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230108629